# EUROPEAN PATENT APPLICATION

(11) **EP 4 535 590 A1**
(43) Date of publication of application: **09.04.2025**
(21) Application number: 23811373.2
(22) Date of filing: 20.02.2023
(51) Int. Cl.: H02J 3/32, B60L 3/00, B60L 53/67, B60L 55/00, B60L 58/16, H01M 10/42, H01M 10/48, H02J 7/00, H02J 13/00

(54) **EV MANAGEMENT SYSTEM**

(30) Priority: 24.05.2022 JP 2022084785
(71) Applicant: Hitachi, Ltd., Tokyo 100-8280 (JP)
(72) Inventor: KOMATSU, Daiki, Tokyo 100-8280 (JP); YAMAUCHI, Shin, Tokyo 100-8280 (JP)
(74) Representative: Mewburn Ellis LLP
(86) International application number: PCT/JP2023/005961
(87) International publication number: WO 2023/228492

(57) **Abstract**

An EV management system (1) includes: a guaranteed characteristic estimation unit (21) that estimates a battery deterioration degree when an EV (13) reaches a vehicle lifespan set in advance, based on information related to an operation history of the EV (13) and information related to a battery deterioration degree based on an actual measurement value; a utilization reserve power calculation unit (25) that calculates a vehicle end-of-lifespan remaining capacity that is a charge/discharge capacity until the EV (13) reaches the vehicle lifespan and a remaining lifespan capacity that is a charge/discharge capacity until a battery (19) reaches a battery lifespan, based on an estimation result of the guaranteed characteristic estimation unit (21), and calculates a reserve power capacity of the battery (19) in a case where the remaining lifespan capacity is larger than the vehicle end-of-lifespan remaining capacity; and an output unit (27) that outputs a calculation result of the utilization reserve power calculation unit (25) as utilization reserve power.

## Description

### Technical Field

The present invention relates to an EV management system that performs management for utilizing an electric vehicle EV for various uses.

### Background Art

In recent years, introduction of renewable energy such as solar power generation and wind power generation has been promoted to realize a decarbonized society. On the other hand, since the renewable energy depends on weather or the like, in a case where it is not possible to satisfy the planned power generation amount due to bad weather or the like, that is, the supply to the demand is insufficient, a risk such as a power failure occurs.

As a countermeasure against this, improvement of prediction accuracy of a power generation amount, compensation for shortage by other power generation such as thermal power generation, compensation for demand response (DR) by adjustable consumer equipment such as air conditioning equipment, lighting equipment, and storage battery equipment, and the like have been variously studied.

In particular, it is expected to be used for a vehicle to grid (V2G) of an electric vehicle EV (Electric Vehicle) among pieces of storage battery equipment which are DR adjustment devices.

PTL 1 discloses a technique for effectively utilizing a battery mounted on an electric moving object. In an information processing method according to PTL 1, first data regarding a load applied to a vehicle body of an electric moving object is acquired, second data regarding an operation of a battery mounted on the moving object is acquired, a remaining lifespan of the vehicle body is calculated based on the first data, a remaining lifespan of the battery is calculated based on the second data, the remaining lifespan of the vehicle body and the remaining lifespan of the battery are compared with each other, and, in a case where the remaining lifespan of the vehicle body is shorter than the remaining lifespan of the battery, at least one of activation of an unused function among a plurality of functions using electric power in the moving object and improvement in performance of the used function is instructed.

According to the information processing method in PTL 1, by bringing the remaining lifespan of the battery mounted on the moving object close to the remaining lifespan of the vehicle body of the moving object, it is possible to effectively utilize the battery without waste.

### Citation List

### Patent Literature

PTL 1: JP 2022-15038 A

### Summary of Invention

### Technical Problem

However, in the battery utilization technique according to PTL 1, it is neither disclosed nor suggested that the EV is utilized for various uses including V2G. Therefore, in the battery utilization technique according to PTL 1, it is not possible to utilize EVs for various uses including V2G.

The present invention has been made in view of the above circumstances, and an object of the present invention is to provide an EV management system capable of utilizing EVs for various uses including V2G.

### Solution to Problem

In order to solve the above problems, according to the present invention, an EV management system is most primarily characterized by including: an information acquisition unit that acquires information related to an operation history of an electric vehicle (EV) equipped with a battery and information related to a battery deterioration degree based on an actual measurement value; an estimation unit that, based on the information related to the operation history of the EV and the information related to the battery deterioration degree, estimates the battery deterioration degree when the EV reaches a vehicle lifespan set in advance; a calculation unit that calculates a vehicle end-of-lifespan remaining capacity that is a charge/discharge capacity until the EV reaches the vehicle lifespan, and a remaining lifespan capacity that is a charge/discharge capacity until the battery reaches a battery lifespan, based on an estimation result of the estimation unit, and calculates a reserve power capacity of the battery in a case where the remaining lifespan capacity is larger than the vehicle end-of-lifespan remaining capacity; and an output unit that outputs the reserve power capacity of the battery that is a calculation result of the calculation unit, as utilization reserve power.

### Advantageous Effects of Invention

According to the present invention, it is possible to obtain the utilization reserve power related to an EV, which is a reserve power capacity of a battery, within a range having no influence on a vehicle lifespan, and thus, it is possible to precisely perform EV management in consideration of vehicle utilization of the EV and V2X utilization.

### Brief Description of Drawings

[FIG. 1] FIG. 1 is a configuration diagram of an EV management system including an EV management device and an EV.
[FIG. 2] FIG. 2 is a functional block diagram illustrating an internal configuration of the EV management device.
[FIG. 3] FIG. 3 is a flowchart for explaining an operation of the EV management device.
[FIG. 4] FIG. 4 is an explanatory diagram comparing a relationship between a guaranteed deterioration characteristic line and a battery deterioration degree of each of a plurality of EVs with an elapsed time as a horizontal axis.
[FIG. 5] FIG. 5 is an explanatory diagram comparing the relationship between the guaranteed deterioration characteristic line and the battery deterioration degree of each of the plurality of EVs with a travel distance as the horizontal axis.
[FIG. 6] FIG. 6 is an explanatory diagram illustrating transition of the battery deterioration degree with respect to a charge/discharge capacity.
[FIG. 7] FIG. 7 is a diagram illustrating a display example of an indicator provided in an output unit of the EV management device.
[FIG. 8] FIG. 8 is a configuration diagram of the EV management system utilizing a deterioration prediction unit.
[FIG. 9] FIG. 9 is a diagram illustrating a data structure of a storage deterioration prediction DB.
[FIG. 10] FIG. 10 is a diagram illustrating a data structure of a cycle deterioration prediction DB.
[FIG. 11] FIG. 11 is a flowchart illustrating a flow of processing when V2G utilization reserve power calculation is performed in a case where an EV operation history is short.
[FIG. 12] FIG. 12 is a flowchart illustrating a flow of processing when a priority is selected with reference to a guaranteed deterioration characteristic and travel distances of a plurality of EVs as management targets.
[FIG. 13] FIG. 13 is an explanatory diagram illustrating a concept of comparison and interval calculation between the guaranteed deterioration characteristic line and a battery deterioration degree of each of a plurality of EVs in an elapsed time.

### Description of Embodiments

Hereinafter, a plurality of embodiments of the present invention will be described with reference to the accompanying drawings.

The following description shows embodiments of the present invention, and the present invention is not limited to these descriptions. In the drawings for describing the present invention, components having the same function are denoted by the same reference signs, and the repetitive description thereof may be omitted.

The present invention discloses an EV management system 1 capable of utilizing an electric vehicle (EV) 13 for various uses including power demand-supply adjustment related to V2G. The EV management system 1 has a role of suitably performing energy management in, for example, a factory, an office, or the like that manages a plurality of commercial vehicles (EVs 13).

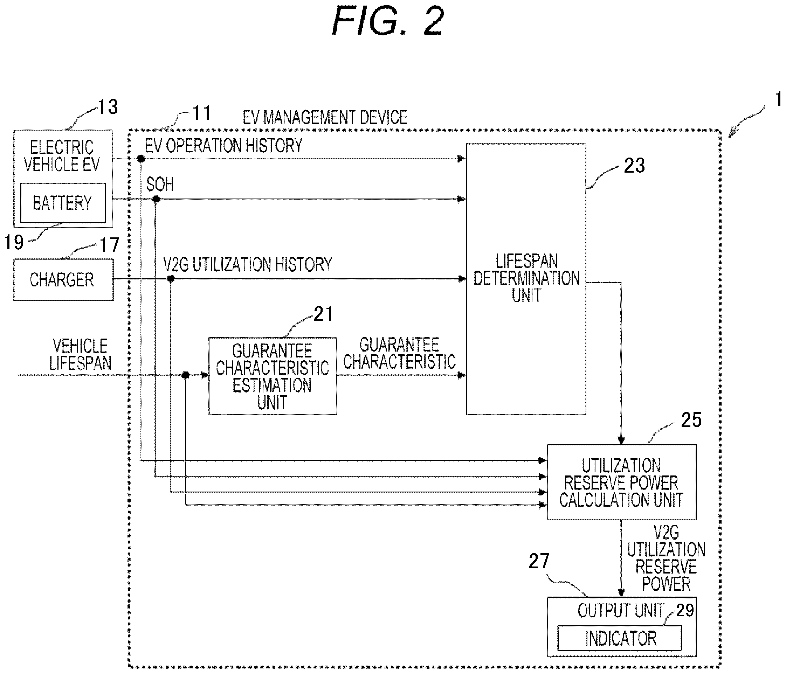

In the EV management system 1, a vehicle end-of-lifespan remaining capacity that is a charge/discharge capacity until the EV 13 reaches a vehicle lifespan (set based on an elapsed time and a travel distance) and a remaining lifespan capacity that is a charge/discharge capacity until a battery 19 (see FIG. 2) reaches a battery lifespan are calculated, and, in a case where the remaining lifespan capacity is larger than the vehicle end-of-lifespan remaining capacity, a reserve power capacity (= remaining lifespan capacity - vehicle end-of-lifespan remaining capacity) related to the EV 13 is used as utilization reserve power for power demand-supply adjustment related to V2G. Note that the reserve power capacity related to the EV 13 may be applied, as the utilization reserve power, to vehicle to everything communication (V2X) having a wider application range than vehicle to grid (V2G).

As a result, for example, it is possible to adjust the power demand-supply balance between regions by using the utilization reserve power related to the EV 13.

### [Embodiment 1]

In the present Embodiment 1, an example in which the EV management system 1 calculates the utilization reserve power related to the EV 13 will be described.

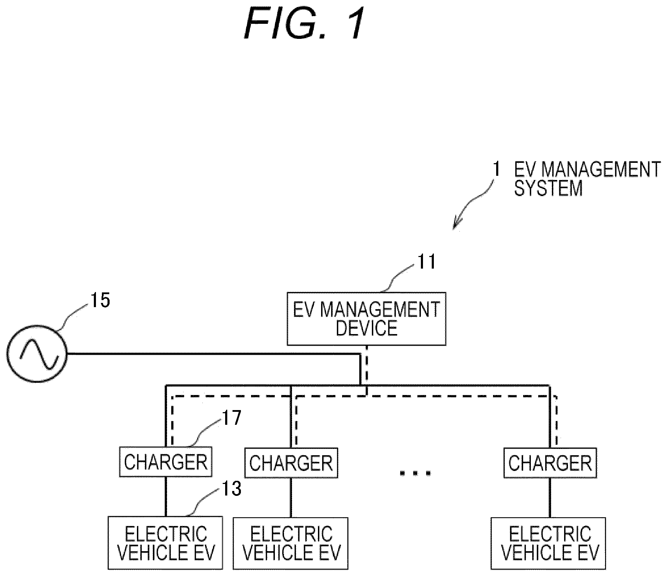

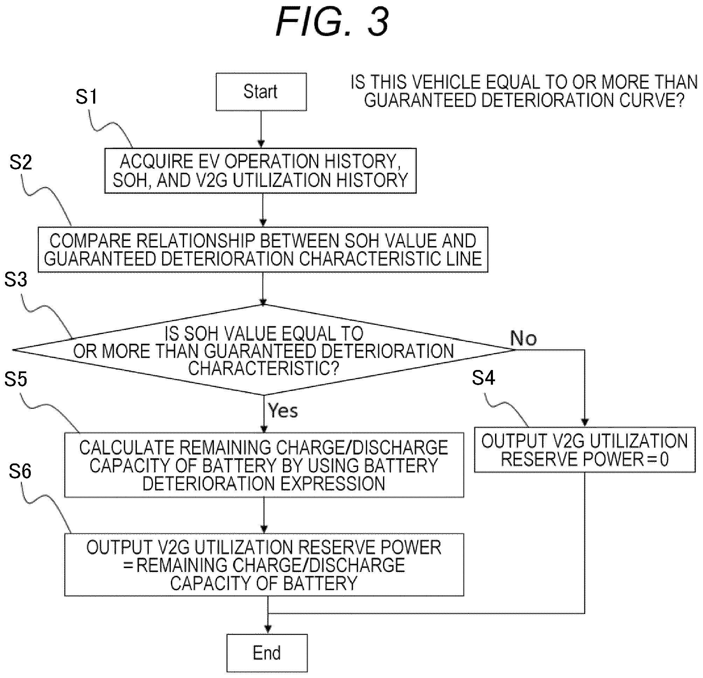

FIG. 1 is a configuration diagram of the EV management system 1 including an EV management device 11 and an EV 13. FIG. 2 is a functional block diagram illustrating an internal configuration of the EV management device 11. FIG. 3 is a flowchart for explaining an operation of the EV management device 11.

As illustrated in FIGS. 1 and 2, the EV management system 1 includes the EV management device 11, a plurality of electric vehicles EV 13 placed in a space such as a parking lot of an office, and a plurality of chargers 17 capable of charging and discharging a power system 15.

The EV management device 11 has a function of acquiring and managing each type of information of the plurality of EVs 13 and the plurality of chargers 17. The internal configuration of the EV management device 11 will be described in detail later.

In the example illustrated in FIG. 1, a configuration in which one charger 17 is connected to each EV 13 is adopted. A configuration in which a plurality of EVs 13 is connected to one charger 17 may be adopted. The EV management device 11 acquires various types of information by performing, for example, CAN communication with the charger 17. In a case where information can be acquired from the EV 13 via the IoT, the means is not limited. With such a configuration, the EV management device 11 can acquire the information of the plurality of EVs 13 and operate.

As illustrated in FIG. 2, the EV management device 11 is configured to include a guaranteed characteristic estimation unit (corresponding to "information acquisition unit" and "estimation unit" in the present invention) 21, a lifespan determination unit (corresponding to a part of "information acquisition unit" in the present invention) 23, a utilization reserve power calculation unit (corresponding to "calculation unit" in the present invention) 25, and an output unit 27.

The lifespan determination unit 23 of the EV management device 11 acquires information of an EV operation history and a battery deterioration degree (SOH: an index representing the soundness or deterioration state of the battery 19) via the EV 13 or the charger 17. The EV operation history is, for example, an elapsed time, a travel distance, an average battery temperature, and an average charging rate (SOC) up to the current time.

An SOH value may be acquired from the EV 13 side, or the charger 17 side may actually measure the SOH value from the behavior of a current/voltage at the time of charging or discharging, and the behavior of input/output power and the SOC.

In addition, the lifespan determination unit 23 of the EV management device 11 acquires information of a charge/discharge power amount (unit: kWh, may be referred to as a charge/discharge capacity) as a V2G utilization history via the charger 17.

The guaranteed characteristic estimation unit 21 (corresponding to a part of "information acquisition unit" in the present invention) of the EV management device 11 inputs and sets an elapsed time and a used travel distance as a vehicle lifespan. In the present embodiment, the elapsed time and the travel distance guaranteed by the vehicle manufacturer side are handled as the vehicle lifespan. Specifically, for example, the guaranteed years of 8 years and the guaranteed travel distance of 160,000 km are calculated as an example of the vehicle lifespan. The lifespan of the battery 19 is set to a capacity retention ratio (SOHQ: subordinate concept of the battery deterioration degree) of 60%.

Note that, in the description of the embodiment of the present invention, description will be made by using the battery deterioration degree (SOH) and the capacity retention ratio (SOHQ) as indices indicating the deterioration state of the battery 19. It is additionally mentioned that these concepts (SOH and SOHQ) may be collectively referred to as "battery deterioration degree".

Here, a deterioration expression used by the EV management device 11 will be described. The battery 19 has storage deterioration that occurs during storage and cycle deterioration that occurs due to the number of times of charging and discharging. In the present Embodiment 1, deterioration estimation is performed by adopting the following expressions (1), (2), and (3). Capacity decrease rate due to storage deterioration = storage deterioration coefficient (based on average battery temperature and average SOC) × √ elapsed time Capacity decrease rate due to cycle deterioration = cycle deterioration coefficient (based on average battery temperature) × charge/discharge capacity (kWh) Capacity retention rate: SOHQ = 100 - capacity decrease rate due to storage deterioration - capacity decrease rate due to cycle deterioration

The capacity deterioration rate due to storage deterioration is calculated by Expression (1). Storage deterioration is generally derived by generation of a reaction-inactive layer (Solid-Electrolyte-Interface: SEI) on a negative electrode surface inside a battery over time. Therefore, a √ rule proportional to √ of the elapsed time is set.

The storage deterioration coefficient is a coefficient that changes by using the average battery temperature and the average SOC as parameters. In the present Embodiment **1,** it is assumed that the storage deterioration coefficient is set in advance by a deterioration test of the battery 19 at the time of design.

Similarly, the capacity decrease rate due to cycle deterioration is calculated by Expression (2).

Unlike storage deterioration, cycle deterioration is not deterioration at a chemical rate, but mainly mechanical deterioration derived from expansion and contraction accompanying charging and discharging. Therefore, cycle deterioration is not necessarily to follow the √ rule. In the present Embodiment **1,** this was defined as a temporary expression based on the charge/discharge capacity (kWh). In addition, the cycle deterioration coefficient is set to a coefficient that changes by using the average temperature as a parameter. It is assumed that the cycle deterioration coefficient is also set in advance by the deterioration test of the battery 19 at the time of design.

A prediction value of the current capacity retention rate related to the battery 19 is calculated by Expression (3).

The guaranteed characteristic estimation unit 21 of the EV management device 11 estimates a guaranteed deterioration characteristic line of the battery 19 by using the vehicle lifespan set in advance and the deterioration expressions of Expressions (1) to (3). The guaranteed deterioration characteristic line is a characteristic line that is referred to as a basis for determining how much SOH (battery deterioration degree) is required to satisfy the guarantee in the case of the current elapsed time and travel distance, by using a deterioration expression described later.

The guaranteed deterioration characteristic line includes a concept of "remaining lifespan capacity" in the present invention.

In Embodiment 1, the criterion for determining the utilization reserve power related to the EV 13 is defined by using a new concept of the guaranteed deterioration characteristic, and thus the utilization reserve power related to the EV 13 can be easily and accurately grasped.

In the present embodiment, it is guaranteed by the manufacturer. For example, when the vehicle (EV 13) is used in a form in which the vehicle is not owned by an individual but in a lease form, or in a case where the vehicle is used in a sharing form, a case where the depreciation is completed even within the guarantee of the manufacturer is also assumed. Therefore, any elapsed time and travel distance can be appropriately input and set as the vehicle lifespan.

The guaranteed characteristic estimation unit 21 adjusts the coefficient assuming the following Expressions (4) to (6). Capacity decrease rate due to storage deterioration = storage deterioration coefficient (battery temperature/average charging rate 100%) × √ vehicle lifespan elapsed time Capacity decrease rate due to cycle deterioration = cycle deterioration coefficient (battery temperature) × charge/discharge capacity at vehicle lifespan (kWh) Capacity retention rate of battery lifespan = 100 - capacity decrease rate due to storage deterioration - capacity decrease rate due to cycle deterioration

First, the elapsed time of the vehicle lifespan: 8 years is input in Expression (4), the average SOC is set to 100%, and only the battery temperature is used as a variable. The average SOC is set to 100% because the EV 13 is often maintained and stored at a high SOC value.

In addition, the charge/discharge capacity (kWh) until reaching the vehicle lifespan is calculated from the average power cost of the EV 13 by Expression (5), and only the battery temperature is used as a variable.

For example, when the average power cost is 10 km/kWh, the charge/discharge capacity (corresponding to "vehicle end-of-lifespan remaining capacity" in the present invention) until reaching the vehicle lifespan is calculated to be 32000 kWh from 160,000 km ÷ 10 km/kWh × 2 (taking charge and discharge into consideration).

In Expression (6), the left side is trial calculated as the capacity retention ratio of the battery lifespan of 60%, the storage deterioration coefficient and the cycle deterioration coefficient are adjusted using the battery temperature as a variable, and a value when the SOHQ becomes 60% is fitted. As a result, the guaranteed deterioration characteristic line for satisfying the vehicle lifespan can be calculated.

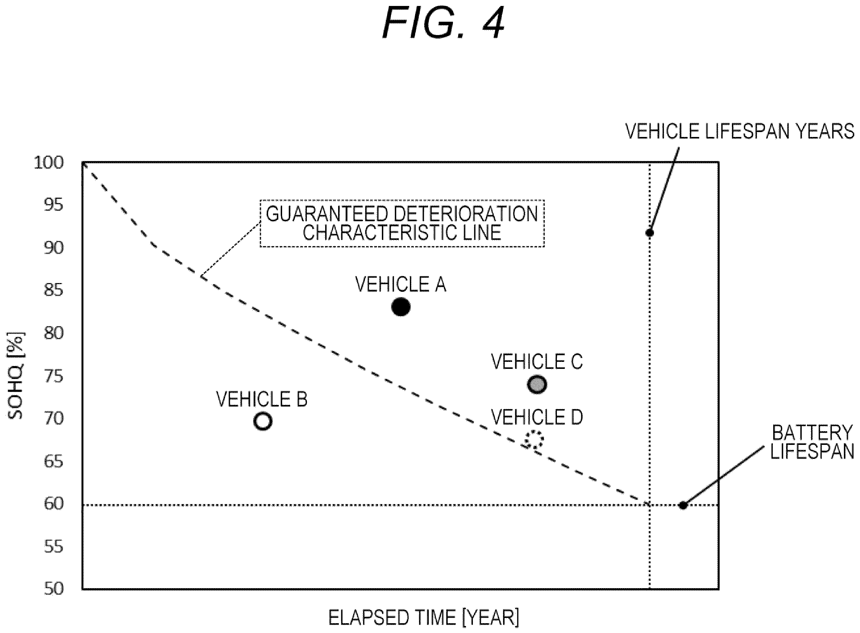

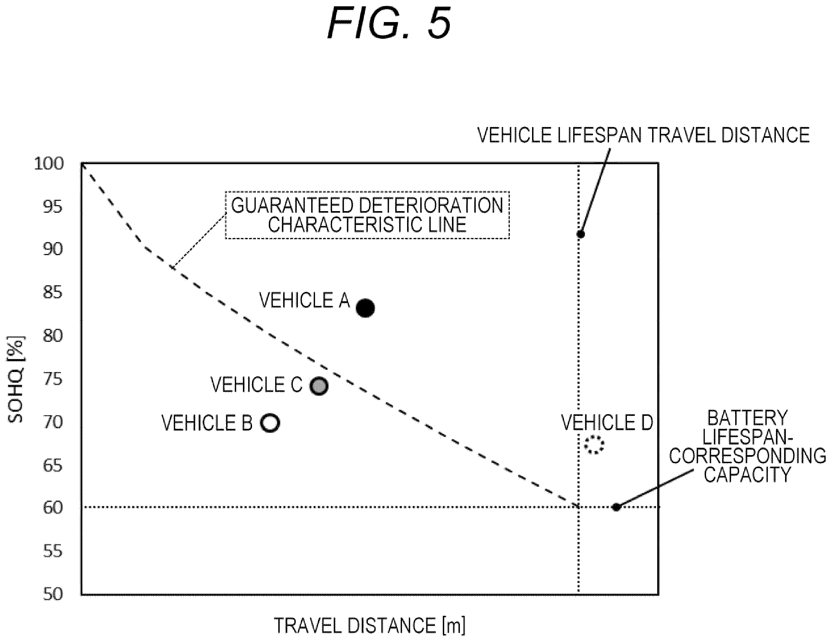

The lifespan determination unit 23 of the EV management device 11 compares the relationship between the current SOH value and the guaranteed deterioration characteristic line. This will be described with reference to FIGS. 4 and **5****.**

FIG. 4 is an explanatory diagram comparing a relationship between the guaranteed deterioration characteristic line and the SOH (battery deterioration degree) of each of a plurality of EVs 13 with an elapsed time as a horizontal axis. FIG. 5 is an explanatory diagram comparing the relationship between the guaranteed deterioration characteristic line and the battery deterioration degree of each of the plurality of EVs 13 with a travel distance as the horizontal axis.

In FIGS. 4 and 5, vehicles A to D are a plurality of vehicles (EVs 13) having different elapsed times and different travel distances in the same vehicle type.

The lifespan determination unit 23 compares the relationship between the current SOH and the guaranteed deterioration characteristic line for each of the vehicles A to D, and determines whether or not a relationship of SOH value < guaranteed deterioration characteristic line is established. In a case where the relationship of SOH value < guaranteed deterioration characteristic line is established, there is concern that the battery lifespan is reached before the vehicle lifespan. In this case, V2G utilization of the vehicle (EV 13) is NG.

Note that, in a case where the relationship of SOH value < guaranteed deterioration characteristic line is established in any one of the vehicle lifespan elapsed time and the vehicle lifespan charge/discharge capacity (kWh), the lifespan determination unit 23 considers that the battery lifespan is reached before the vehicle lifespan, and sets the V2G utilization reserve power of the corresponding battery 19 to 0.

In the examples illustrated in FIGS. 4 and 5, the vehicle B and the vehicle C are NG targets (utilization reserve power = 0). For example, the battery deterioration degree (SOHQ) of the vehicle C exceeds the guaranteed deterioration characteristic line from the viewpoint of the elapsed time, but is less than the guaranteed deterioration characteristic line from the viewpoint of the charge/discharge capacity (kWh) according to the travel distance. Therefore, there is a concern that it is not possible to satisfy the guarantee, and thus the V2G utilization reserve power is set to 0.

On the other hand, in a case where a relationship of SOH value ≥ guaranteed deterioration characteristic line is established, the vehicle lifespan is reached before the battery lifespan in the current usage. Thus, it is considered that the battery 19 has utilization reserve power.

In this case, the utilization reserve power calculation unit 25 calculates the utilization reserve power related to the EV 13 (battery 19).

Even in a case where the vehicle lifespan is already satisfied, that is, in a case where any one of 8 years and 160,000 km is satisfied, the vehicle (EV 13) is already in a state of waiting for disposal, and thus there is no problem in using the vehicle as the battery 19.

In the examples illustrated in FIGS. 4 and 5, the vehicle B and the vehicle C are OK targets (with utilization reserve power).

Note that the vehicle D satisfies the requirements as a vehicle because the travel distance exceeds the guaranteed distance (vehicle lifespan travel distance).

The utilization reserve power calculation unit 25 calculates the remaining charge/discharge capacity (kWh) of the battery 19, which serves as the vehicle lifespan and the battery lifespan, by using a battery deterioration expression. Therefore, the following Expressions (7) to (9) are established by utilizing Expressions (1) to (3). Capacity decrease rate due to storage deterioration = storage deterioration coefficient (average battery temperature/average SOC) × √ vehicle lifespan elapsed time Capacity decrease rate due to cycle deterioration = cycle deterioration coefficient (average battery temperature) × (charge/discharge capacity (kWh) until reaching vehicle lifespan + remaining charge/discharge capacity (kWh)) Capacity retention rate of battery lifespan = 100 - capacity decrease rate due to storage deterioration - capacity decrease rate due to cycle deterioration

In Expression (7), the deterioration coefficient is set based on the battery temperature and the average SOC acquired via the EV 13, and the capacity decrease rate when reaching the vehicle lifespan elapse time is calculated.

In Expression (8), the capacity decrease rate is calculated based on the sum of the charge/discharge capacity (kWh) and the remaining charge/discharge capacity (kWh) up to the current time, which is the sum of the charge/discharge capacity (kWh) and the V2G utilization amount converted based on the battery temperature and the travel distance acquired via the EV 13.

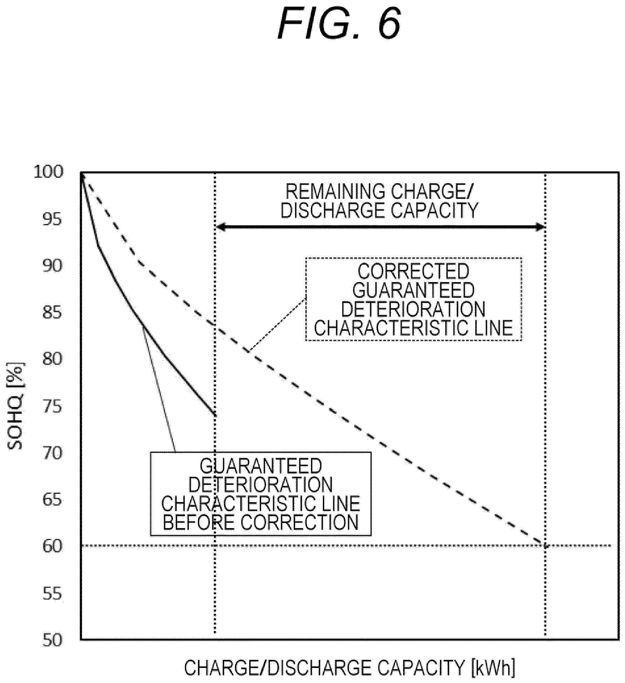

In Expression (9), the remaining charge/discharge capacity (kWh) that is the capacity retention rate of the battery lifespan is calculated. FIG. 6 illustrates this image. FIG. 6 is an explanatory diagram illustrating transition of the battery deterioration degree with respect to the charge/discharge capacity.

A solid line illustrated in FIG. 6 indicates the guaranteed deterioration characteristic line before correction when the remaining charge/discharge capacity (kWh) is 0, that is, in a case where a target vehicle/battery travels in the current state (deterioration coefficient) until reaching the elapsed time/travel distance defined as the vehicle lifespan.

On the other hand, a dotted line illustrated in FIG. 6 indicates a corrected guaranteed deterioration characteristic line obtained by adding the remaining charge/discharge capacity (kWh) that is the capacity retention rate of the battery lifespan. The difference on the horizontal axis is the remaining charge/discharge capacity (kWh). For the vehicle D exceeding the vehicle lifespan, the guaranteed deterioration characteristic line represents the guaranteed deterioration characteristic line up to the current time, and the corrected guaranteed deterioration characteristic line is calculated in a calculation of only adding the remaining charge/discharge capacity (kWh) to Expression (8). Since the vehicle lifespan elapsed time and the charge/discharge capacity (kWh) until reaching the vehicle lifespan have already exceeded, the current value is input and calculated.

With such a configuration, it is possible to expect an effect of using the EV 13 whose vehicle lifespan has come without waste.

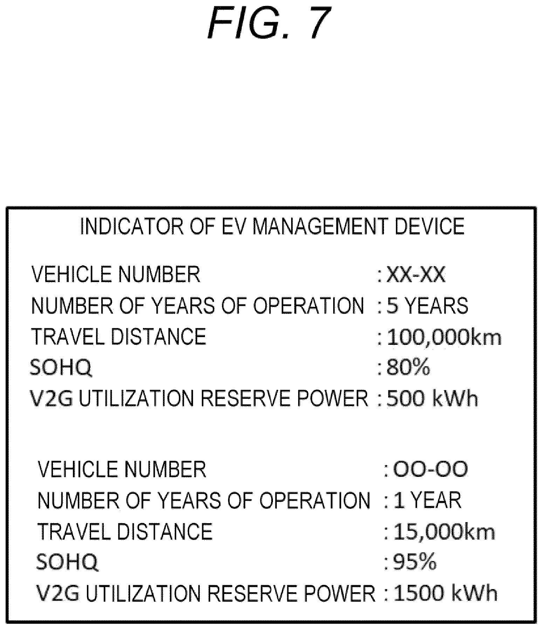

As illustrated in FIG. 7, the output unit 27 of the EV management device 11 displays the V2G utilization reserve power on an indicator 29. FIG. 7 is a diagram illustrating a display example of the indicator 29 provided in the output unit 27 of the EV management device 11. The output unit 27 may output the V2G utilization reserve power to a higher-level controller such as the XEMS in addition to the display on the indicator 29.

As illustrated in FIG. 7, the EV management device 11 manages each type of vehicle number information in association with the operation years, the travel distance, SOHQ information, and the V2G utilization reserve power, so that it is possible to promote the V2G utilization related to the corresponding vehicle (EV 13) having exceeded the vehicle lifespan.

In addition, it is possible to expect an effect of appropriately managing the utilization reserve power by displaying the required utilization reserve power related to the EV 13.

Next, the operation of the EV management device 11 according to Embodiment 1 will be described with reference to FIG. **3****.**

In Step S1 illustrated in FIG. 3, the EV management device 11 acquires information of an EV operation history, a battery deterioration degree (SOH), and a V2G utilization history.

In Step S2, the lifespan determination unit 23 of the EV management device 11 compares the relationship between the current SOH value and the guaranteed deterioration characteristic line.

In Step S3, the lifespan determination unit 23 of the EV management device 11 determines whether or not the current SOH value is more than or equal to the guaranteed deterioration characteristic. As a result of the determination in Step S3, in a case where the current SOH value is less than the guaranteed deterioration characteristic, that is, in a case where the relationship of SOH value < guaranteed deterioration characteristic line is established, the EV management device 11 causes the processing flow to proceed to Step S4.

On the other hand, as the result of the determination in Step S3, in a case where the current SOH value is more than or equal to the guaranteed deterioration characteristic, that is, in a case where the relationship of SOH value ≥ guaranteed deterioration characteristic line is established, the EV management device 11 causes the processing flow to proceed to Step S5.

In Step S3, the lifespan determination unit 23 of the EV management device 11 may adopt a configuration that performs condition determination of whether the current SOH value is equal to or more than the guaranteed deterioration characteristic or whether the current SOH value exceeds the vehicle lifespan.

In this case, as the result of the determination in Step S3, in a case where the current SOH value is less than the guaranteed deterioration characteristic and equal to or less than the vehicle lifespan, the EV management device 11 causes the processing flow to proceed to Step S4.

On the other hand, in a case where the current SOH value is more than or equal to the guaranteed deterioration characteristic or exceeds the vehicle lifespan (one of them is satisfied), the EV management device 11 causes the processing flow to proceed to Step S5.

In Step S4, the output unit 27 of the EV management device 11 outputs information of V2G utilization reserve power = 0 (no V2G utilization reserve).

In Step **S5,** the utilization reserve power calculation unit 25 of the EV management device 11 calculates the remaining charge/discharge capacity (kWh) of the battery 19 by using the above-described battery deterioration expression.

In Step S6, the output unit 27 of the EV management device 11 outputs information of V2G utilization reserve power = remaining charge/discharge capacity of the battery 0 (with V2G utilization reserve power).

Thereafter, the EV management device 11 ends the flow of the series of processing.

### [Embodiment 2]

In Embodiment 2, a method of correcting the deterioration expression itself from the actual measurement value will be described. The deterioration expressions (1) to (3) are fixed at the design stage in Embodiment **1,** but may be corrected in consideration of the actual driving environment of the vehicle (EV 13).

This content will be described below. In a case where there is no change in the deterioration expressions (1) to (3), the storage deterioration coefficient and the cycle deterioration coefficient are parameters that need to be designed in advance. These coefficients may be different from previous deterioration test results under a charge/discharge test environment in an actual environment. Therefore, for example, it is effective to calculate these coefficients from statistical data analysis in terms of accuracy improvement.

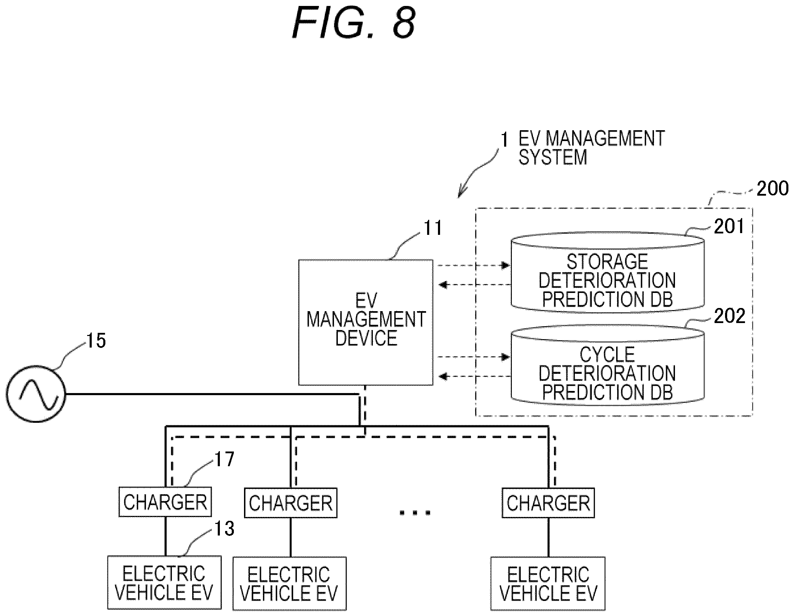

FIG. 8 illustrates this configuration. FIG. 8 is a configuration diagram of an EV management system 1 utilizing a deterioration prediction unit 200.

The basic components of the EV management system 1 illustrated in FIG. 8 are similar to those of FIG. **1****,** but a configuration in which the EV management device 11 communicates with the deterioration prediction unit 200 is added.

The deterioration prediction unit 200 includes a storage deterioration prediction DB 201 and a cycle deterioration prediction DB 202. In practice, the deterioration prediction unit 200 is desirably mounted on a cloud or a large-sized server machine.

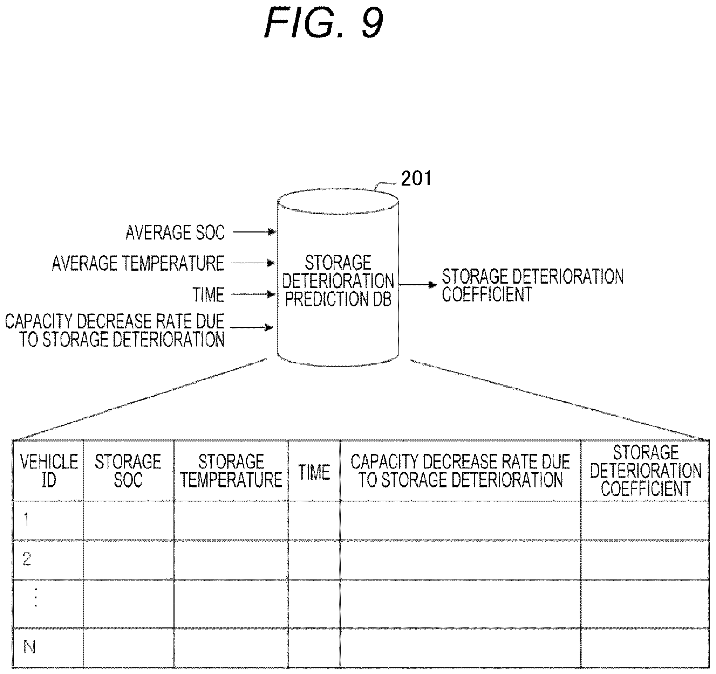

FIG. 9 illustrates the configuration of the storage deterioration prediction DB 201. FIG. 9 is a diagram illustrating a data structure of the storage deterioration prediction DB.

Regarding Expression (1) indicating storage deterioration, the capacity decrease rate due to storage deterioration can be calculated from the average SOC, the average temperature, and the time.

Thus, by aggregating information of each of the average SOC, the average temperature, the time, and the capacity decrease rate due to storage deterioration for each of a plurality of vehicles in the storage deterioration prediction DB 201, the storage deterioration coefficient can be calculated by processing such as machine learning. At this time, it is difficult to originally separate the capacity decrease rate due to storage deterioration from the capacity decrease rate due to cycle deterioration.

In a case where the storage deterioration prediction DB 201 is utilized, it is important to separate the storage deterioration prediction DB at the time of input. Therefore, for example, it is possible to improve accuracy by extracting only a pause period during which only storage is performed without traveling and inputting the extracted pause period to the storage deterioration prediction DB 201.

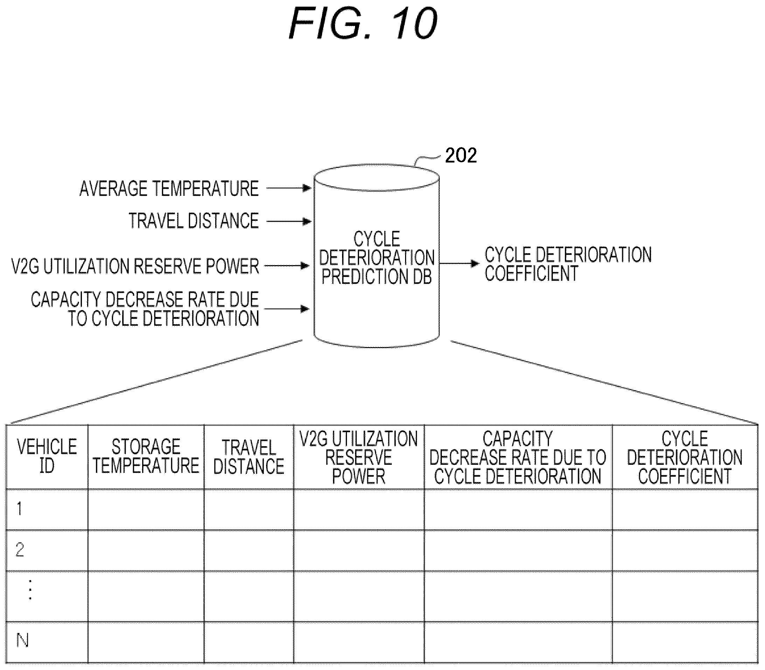

FIG. 10 illustrates the configuration of the cycle deterioration prediction DB 202. FIG. 10 is a diagram illustrating a data structure of the cycle deterioration prediction DB 202.

Regarding Expression (2) indicating cycle deterioration, the capacity decrease rate due to cycle deterioration can be calculated from the average temperature, the travel distance, and the V2G utilization amount.

Thus, by aggregating information of each of the average temperature, the travel distance, the V2G utilization amount, and the capacity decrease rate due to cycle deterioration for each of a plurality of vehicles in the cycle deterioration prediction DB 202, the cycle deterioration coefficient can be calculated by processing such as machine learning. At this time, it is difficult to originally separate the capacity decrease rate due to cycle deterioration from the capacity decrease rate due to storage deterioration.

In a case where the cycle deterioration prediction DB 202 is utilized, it is important to separate the storage deterioration prediction DB at the time of input. Therefore, for example, it is possible to achieve the improvement in the accuracy by limitation to only a busy operation period in which the travel distance and the V2G utilization are large, extracting only the capacity decrease rate due to cycle deterioration obtained by subtracting the capacity decrease rate due to storage deterioration in the corresponding busy section, and inputting the extracted capacity decrease rate to the cycle deterioration prediction DB 202.

In Embodiment 2, the remaining battery charge/discharge capacity (kWh) is calculated based on the guaranteed deterioration characteristic line and the battery deterioration expression, by using the storage deterioration coefficient and the cycle deterioration coefficient calculated with reference to the deterioration prediction unit 200, as in Embodiment 1.

With the EV management system 1 according to Embodiment 2, since the deterioration prediction expression is corrected by using the information of the EV operation history and the battery deterioration degree related to each of a plurality of EVs 13, it is possible to expect the effect of improving the accuracy of the utilization reserve power related to the EV 13.

### [Embodiment 3]

In Embodiment 3, contents of changing the processing described in Embodiment 1 will be described for a vehicle (EV 13) having a small use history, that is, a small elapsed time or a small travel distance.

In a case where the elapsed time or the travel distance is small, since the deterioration does not progress, there is a margin in the utilization reserve power that can be utilized in V2G. In addition, it is difficult to grasp what deterioration transition is followed before a certain time elapses. Therefore, the accuracy of the deterioration prediction also decreases.

Thus, at a timing at which the deterioration does not progress, it is desirable to utilize the fixed value grasped at the time of design without performing the estimation processing as described in Embodiment 1.

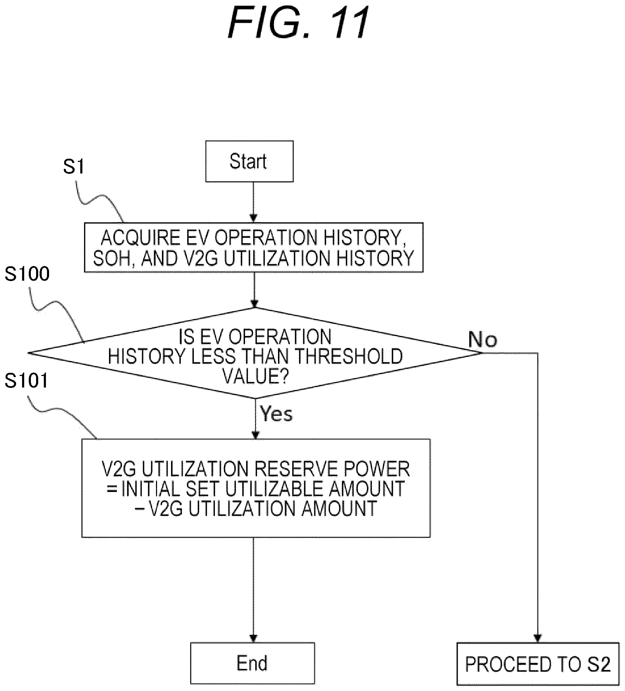

An operation of an EV management system 1 according to Embodiment 3 will be described with reference to FIG. 11.

FIG. 11 is a flowchart illustrating a flow of processing when V2G utilization reserve power calculation is performed in a case where the EV operation history is short.

In Step S1 illustrated in FIG. 3, the EV management device 11 acquires information of an EV operation history, a battery deterioration degree (SOH), and a V2G utilization history.

In Step S100 illustrated in FIG. 11, the EV management device 11 determines whether or not the EV operation history is less than a threshold value set in advance.

The EV operation history is, for example, the operation years or the travel distance. As the threshold value set in advance, for example, a value that can be considered as having a short EV operation history, such as the operation year: 1 year or the travel distance of 20,000 km, may be appropriately set.

As a result of the determination in Step S100, in a case where the EV operation history is equal to or more than the threshold value set in advance, that is, in a case where the EV operation history is not so short, the EV management device 11 causes the processing flow to proceed to Step S2 (normal processing) in FIG. **3****.**

On the other hand, as the result of the determination in Step S100, in a case where the EV operation history is less than the threshold value set in advance, that is, in a case where the EV operation history is short, the EV management device 11 causes the processing flow to proceed to Step S101 (exception processing).

In Step S100, the utilization reserve power calculation unit 25 of the EV management device 11 calculates the V2G utilization reserve power by using the following Expression (10). V2G utilization reserve power = initial setting V2G utilizable amount - V2G utilization amount

The initial setting V2G utilizable amount is an amount permitted to be utilized for V2G set at the time of design. This value can be appropriately changed to any value at the time of design.

The V2G utilization amount is a charge/discharge capacity (kWh) when the EV 13 has performed V2G until now. In such a situation where the operation history is short, the deterioration progress is small, and the prediction accuracy cannot be maintained, exception processing is performed as in the above Expression (10).

With the EV management system 1 according to Embodiment **3,** it is possible to promote the V2G utilization for the EV 13 having a short EV operation history in an undeteriorated state that hardly affects the vehicle lifespan.

### [Embodiment 4]

In Embodiment **4,** a method of selecting the priority when the EV management device 11 performs V2G utilization among a plurality of EVs 13 in a case where there is the plurality of vehicles (EVs 13) as management targets will be described.

As a premise, even though the V2G utilization reserve power is calculated by using each method in Embodiments 1 to **3,** in a case where there is a plurality of EVs 13 as management targets, and, for example, supply and demand adjustment power for one EV is required, it is difficult to precisely determine which EV 13 is preferentially used in consideration of economic requirements and the like.

This is because, in a case where there is a plurality of EVs 13 as the management targets, even though there is an EV having a large utilization reserve power due to a short EV operation history, in a case where there is a vehicle (EV 13) whose scheduled vehicle disposal timing comes close to the vehicle lifespan, there is a circumstance that it is economically advantageous to give a priority to the latter.

In order to solve such a problem, an EV management system 1 according to Embodiment 4 discloses a new method of selecting a priority when the EV management device 11 performs V2G utilization in a case where there is a plurality of EVs 13 as management targets.

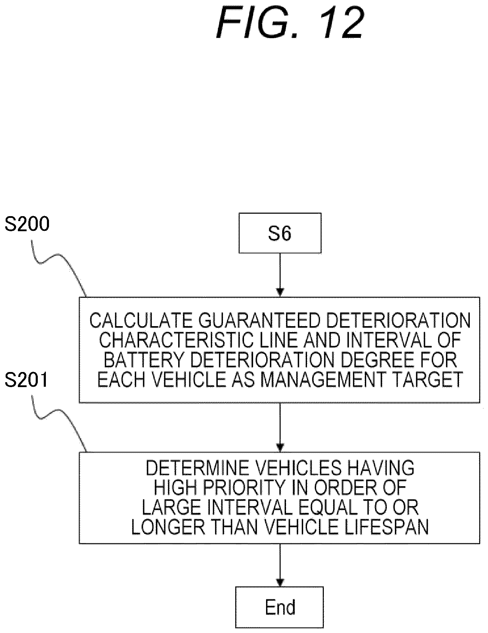

FIG. 12 is a flowchart illustrating a flow of processing when a priority is selected with reference to the guaranteed deterioration characteristic and travel distances of a plurality of EVs 13 as management targets. The processing illustrated in FIG. 12 is performed after Step S6 illustrated in FIG. 3.

In Step S200 illustrated in FIG. 12, an EV management device 11 calculates the guaranteed deterioration characteristic line and the interval of the battery deterioration degree for each vehicle (EV 13) as the management target.

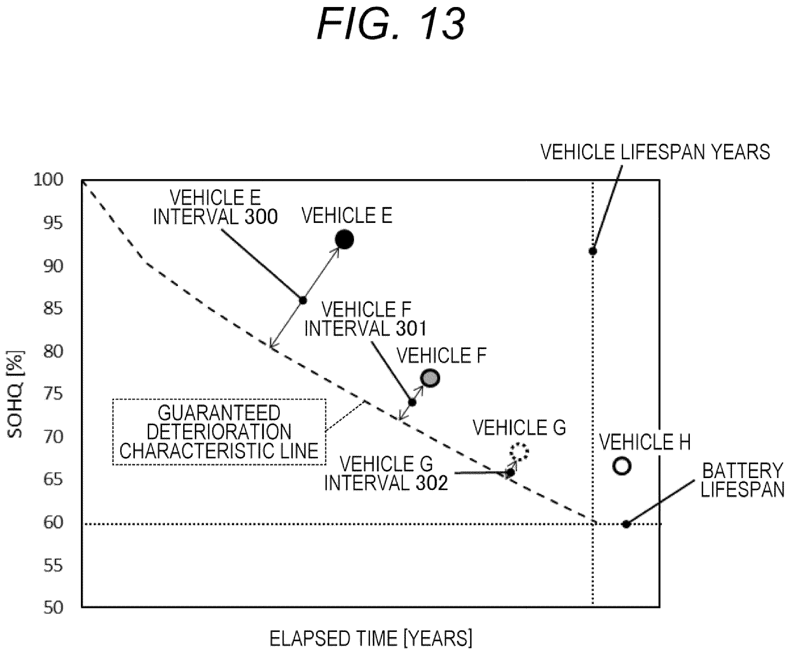

This will be described with reference to FIG. 13. FIG. 13 is obtained by plotting battery deterioration degrees and the operation years of four other vehicles (EVs 13) to the same graph as FIG. 4.

"Interval" referred to in S200 means a vehicle E interval 300, a vehicle F interval 301, and a vehicle G interval 302 as illustrated in FIG. 13. This corresponds to the length of the shortest path connecting the plotted position of each vehicle (EV 13) and the guaranteed deterioration characteristic line. The larger the interval is, the more utilization reserve power is with respect to the guaranteed deterioration characteristic line.

Therefore, the vehicle (EV 13) having a larger interval is preferentially selected as the V2G utilization target among the plurality of EVs 13 as the management targets. As a result, it is possible to appropriately select the EV 13 to be set as a V2G utilization target.

The vehicle H illustrated in FIG. 13 is a vehicle that has exceeded the vehicle lifespan but is still operable (has utilization reserve power). However, since the vehicle H is about to be disposed, the vehicle H should be effectively used with the highest priority.

Therefore, in Step S201, the EV management device 11 determines the vehicle (EV 13) having a high priority in the order of the large interval equal to or longer than the vehicle lifespan.

Thus, with the invention according to Embodiment **4, in** a case where there is a plurality of EVs 13 as management targets, since the priority when the EV management device 11 selects a V2G utilization target is applied in order of the large interval equal to or longer than the vehicle lifespan, V2G utilization can be performed in order of the vehicle **H,** the vehicle **E,** the vehicle **F,** and the vehicle **G,** and it is possible to further improve the economic efficiency and convenience.

Note that, in the present Embodiment 4, as illustrated in FIG. 13, an example in which the elapsed time is taken on the horizontal axis has been described. As illustrated in FIG. 5, similar processing may be performed by using a graph in a case where the travel distance is taken on the horizontal axis.

With the EV management system 1 according to Embodiment 4, even in a case where there is a plurality of EVs 13 as the management targets, it is possible to expect an effect of selecting an appropriate EV 13.

### [Extension of Embodiment]

The plurality of embodiments according to the present invention have been described in detail in order to describe the present invention in an easy-to-understand manner, and are not necessarily limited to those having all the described configurations. Regarding some components in the embodiments, other components can be added, deleted, and replaced. In addition, the above-described configuration is illustrated as being necessary for the description, and not all configurations in terms of a product are necessarily illustrated.

### Reference Signs List

1 EV management system
11 EV management device
13 EV
15 power system
17 charger
19 battery
21 guaranteed characteristic estimation unit
23 lifespan determination unit (information acquisition unit)
25 utilization reserve power calculation unit (calculation unit)
27 output unit
29 indicator
200 deterioration prediction unit
201 storage deterioration prediction DB
202 cycle deterioration prediction DB
300 vehicle E interval
301 vehicle F interval
302 vehicle G interval

## Claims

1. An EV management system comprising:
an information acquisition unit that acquires information related to an operation history of an EV equipped with a battery and information related to a battery deterioration degree based on an actual measurement value;
an estimation unit that estimates, based on the information related to the EV operation history of the EV and the information related to the battery deterioration degree, a battery deterioration degree when the EV reaches a vehicle lifespan set in advance;
a calculation unit that calculates a vehicle end-of-lifespan remaining capacity that is a charge/discharge capacity until the EV reaches the vehicle lifespan, and a remaining lifespan capacity that is a charge/discharge capacity until the battery reaches a battery lifespan, based on an estimation result of the estimation unit, and calculates a reserve power capacity of the battery in a case where the remaining lifespan capacity is larger than the vehicle end-of-lifespan remaining capacity; and
an output unit that outputs the reserve power capacity of the battery that is a calculation result of the calculation unit, as utilization reserve power.

2. The EV management system according to claim **1,** wherein
the estimation unit estimates a guaranteed deterioration characteristic that causes the vehicle lifespan of the EV to coincide with the battery lifespan, and
with lifespan determination based on the guaranteed deterioration characteristic, the calculation unit considers the reserve power capacity of the battery as the utilization reserve power in a case where the battery lifespan of the EV exceeds the vehicle lifespan, and considers that there is no utilization reserve power of the battery in a case where the battery lifespan of the EV is equal to or less than the vehicle lifespan.

3. The EV management system according to claim 1 or **2,** wherein the utilization reserve power of the battery is utilized for **V2X.**

4. The EV management system according to claim **3,** wherein the output unit causes an indicator to display the utilization reserve power related to the V2X.

5. The EV management system according to claim 1 or 2, wherein in a case where the EV has been traveling beyond an elapsed time and a travel distance defined in advance as the vehicle lifespan, the reserve power capacity of the battery that is a difference between the remaining lifespan capacity and a current charge/discharge capacity is considered as the utilization reserve power.

6. The EV management system according to claim 1 **or 2,** wherein the estimation unit corrects a deterioration prediction expression for predicting the battery deterioration degree by using the EV operation history and the battery deterioration degree of each of a plurality of EVs.

7. The EV management system according to claim 6, wherein
the deterioration prediction expression is established based on prediction of storage deterioration and cycle deterioration,
in the prediction of the storage deterioration, a deterioration coefficient is determined based on an average SOC and an average temperature of the EV during a pause period and a capacity decrease rate of the EV during the pause period, and
in the prediction of the cycle deterioration, the deterioration coefficient is corrected based on an average temperature, a travel distance, a V2G utilization amount in an operation period of the EV, and the capacity decrease rate obtained by subtracting an influence of the storage deterioration in the operation period.

8. The EV management system according to claim 1 or 2, wherein in a case where the EV operation history is less than a predetermined threshold value, the estimation unit considers, as the utilization reserve power, a value obtained by subtracting a capacity utilized for a use other than the EV until the present from an initial setting utilizable amount related to the battery, the initial setting utilizable amount being set in advance.

9. The EV management system according to claim 2, wherein EV management is performed to preferentially V2X-utilize an EV in which an interval between the guaranteed deterioration characteristic and the battery deterioration degree with respect to the operation history of the EV, among a plurality of EVs.

10. The EV management system according to claim 1 or 2, wherein EV management is performed to preferentially V2X-utilize an EV exceeding the vehicle lifespan, among a plurality of EVs.
